Europäisches Patentamt

European Patent Office

Office européen des brevets

(11) Publication number: **0 504 575 A2**

# EUROPEAN PATENT APPLICATION

(21) Application number: **92102099.6**

(22) Date of filing: **07.02.92**

(51) Int. Cl.⁵: **G06K 15/12**, B41J 2/45

(30) Priority: **22.03.91 JP 58670/91**

(43) Date of publication of application:
**23.09.92 Bulletin 92/39**

(84) Designated Contracting States:
**DE FR GB**

(71) Applicant: **EASTMAN KODAK COMPANY**
**343 State Street**
**Rochester, New York 14650-2201(US)**

(72) Inventor: **Takahashi, Masaru, c/o EASTMAN**
**KODAK COMPANY**
**Patent Legal Staff, 343 State Street**
**Rochester, New York 14650-2201(JP)**

(74) Representative: **Wagner, Karl H.**
**WAGNER & GEYER Patentanwälte**
**Gewürzmühlstrasse 5 Postfach 246**
**W-8000 München 22(DE)**

(54) **Light-emitting diode device.**

(57) A light-emitting diode (LED) device is disclosed which incorporates channels for distributing signals received from an external source directly into serially-connected LED array driver integrated circuits (ICs) of the LED device. Each LED array driver ICs comprises a plurality of input connection pads and output connection pads. Electrical power, drive data signals, clock signals, and control signals received via an input connector and input board from the external source are supplied directly to the input pads of each LED array driver IC from the input board or an adjacent driver IC in the series without requiring a spreader board as found in prior art LED devices. Such arrangement permits smaller and faster LED devices than present LED devices. The drive data signals received at the predetermined input pads are converted to parallel signals by a serial-to-parallel shift register, and are then applied in parallel to the LED array, and serial data that passes through the shift register is outputted without modification to serial drive data output pad means.

FIG. 4

## Field of the Invention

The present invention relates to a light-emitting diode (LED) device, and, more particularly, to an LED device having an integrated LED array suitable for use in electrophotographic type optical printers.

## Background of the Invention

Electrophotographic type optical printers that comprise a laser light source have been in use for some time. More recently, the use of optical printers has been advanced by the use of a light-emitting diode (LED) array as the light source. Such optical printer requires an LED device for modulating light emitted by the LED array to form an image on a photosensitive element.

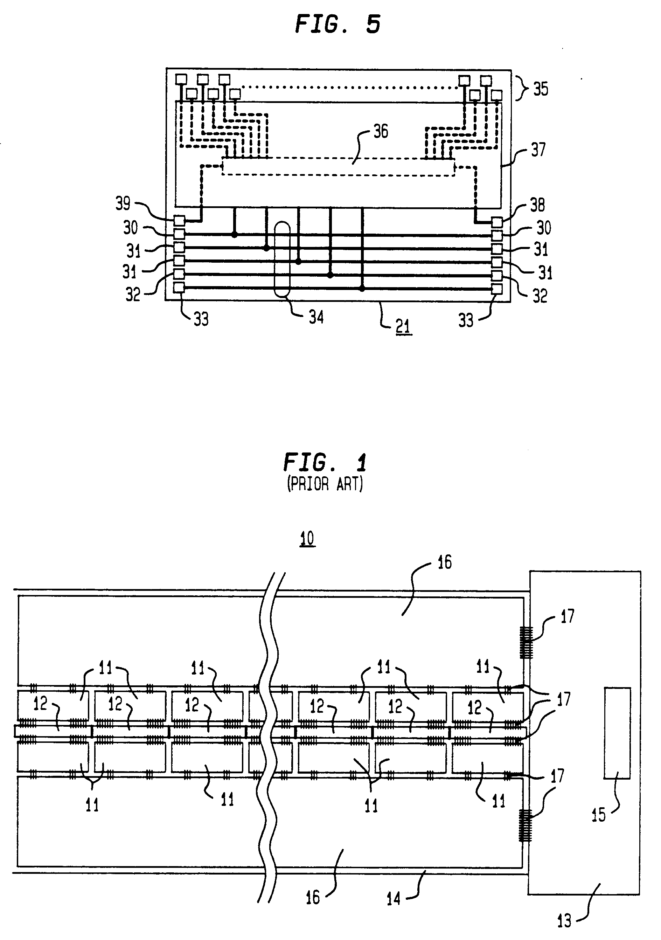

Referring now to FIG. 1, there is shown a plan view of a general structure of a conventional (prior art) LED device 10. The LED device 10 comprises LED arrays 12, LED array driver integrated circuits (ICs) 11 for driving the LED arrays 12, an input board 13 for transmitting electrical power and emission data signals, a motherboard 14 for mounting the ICs 11 and LED arrays 12, an input connector 15 for connecting the power and emission data signals from an external source to the input board 13, a pair of spreader boards 16 for distributing the power supply and emission data signals from the input board 13 to the LED array driver ICs 11, and wire bondings 17 for electrically connecting (a) the LED arrays 12 with the LED array driver ICs 11, (b) the LED array driver ICs 11 with the spreader boards 16, and (c) the spreader boards 16 with the input board 13.

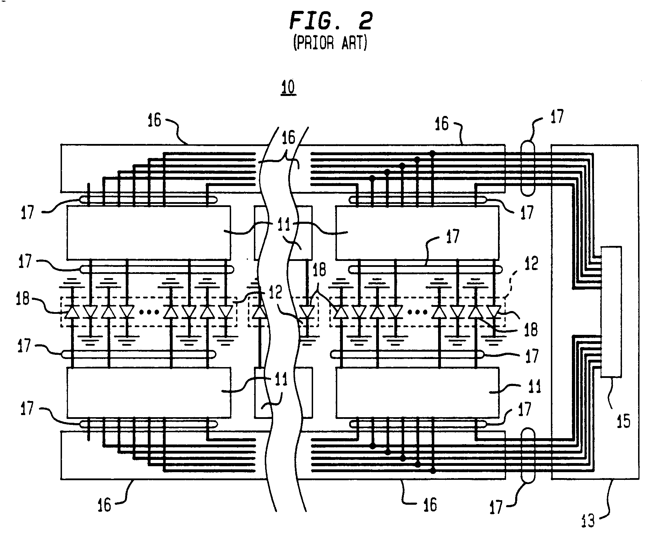

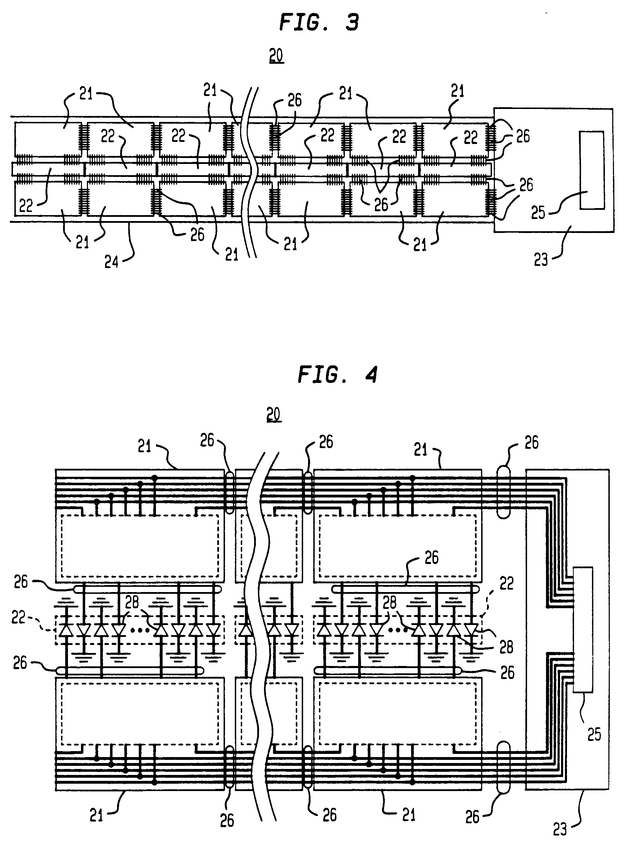

Referring now to FIG. 2, there is shown a more detailed wiring schematic for the prior art LED device 10 of FIG. 4 and further showing each LED array 12 (shown within a dashed line rectangle) comprising a plurality of LEDs 18. It is to be understood that the number designations used for the various components of the LED device 10 shown in FIG. 1 are used for corresponding components shown in FIG. 2.

In operation, electrical power, serial drive data signals, clock signals, control signals, exposure data signals and so forth (hereinbefore termed as electrical power and emission data signals) are applied to the LED device 10 from an external source. The electrical power and emission data signals enter the LED device 10 via the input connector 15 and the input board 13, and are transmitted to the spreader board 16 via wire bondings 17. From the spreader board 16, the electrical power and emission data signals are transmitted to the LED array driver ICs 11. In the LED array driver ICs 11, the serial drive data signals (forming part of the emission data signals) are converted to parallel data to drive the individual LEDs 18 of the LED arrays 12 under the control of control signals. Two LED array driver ICs 11 are used for each LED array 12, one LED array driver IC 11 to drive, for example, the odd-numbered LEDs 18 in the LED array 12 and the other LED array driver IC 11 to drive, for example, the even-numbered LEDs 18 in the LED array 12.

A problem occurs in trying to reduce the overall size of the prior art device 10, in that there is a limit to the reduction in size that is possible with the spreader boards 16. The spreader board 16 is, for example, a glass-epoxy multilayer board. The size of such spreader board 16 imposes a limit on how far the size of the LED device 10 can be reduced. One way to improve the performance of the LED device 10 is to increase its speed by reducing the time the LED device 10 takes to transmit emission data. However, a number of major problems must be solved in order to increase the speed of the LED device 10. For example, when the clock signals and serial drive data are supplied to the LED array driver ICs 11 via the spreader board 16, the signal waveforms are distorted by electrical discontinuities on the spreader board 16, and induction interference of the signals on the spreader board 16 give rise to data errors.

## Summary of the Invention

The present invention is directed to providing a light-emitting diode (LED) device which is made smaller and faster than prior art LED devices by incorporating the function of the spreader board found in prior art LED devices into each LED driver IC chip associated with an LED array.

The LED device in accordance with the present invention comprises an input connector, at least one LED array, and at least one LED array driver integrated circuit (IC) chip. The input connector is used for receiving a multiplicity of electrical power and data signals from an external source. Each LED array comprises a plurality of LEDs. Each LED array driver IC chip is connected in series with other ones of the at least one LED array driver IC circuits and located in the vicinity of the at least one LED array. The at least one LED array driver IC chips are used for driving the LEDs of the at least one LED array. Each of the at least one LED array driver IC chips comprise input pads, means for driving the at least one LED array, and output pads. The input pads are disposed for receiving the multiplicity of electrical power and data signals directly from the input connector when an LED array driver IC chip is a first LED array driver IC chip in the series of LED array driver IC chips, and for receiving the multiplicity of electrical power and data signals from an adjacent LED array driver IC chip in the series of IC chips when the LED array driver IC chip is not a first one in the series of IC chips. The means for driving the at least one LED array drives the LEDs of the LED array in accordance with the multiplicity of electrical power and data signals received at the input pads. The output pads are disposed for outputting the multiplicity of electrical power and data signals as received at the input pads to a next adjacent LED array driver IC chip in the series of IC chips.

In a first embodiment of the LED device in accordance with the present invention, each LED array has a pair of LED array driver IC chips associated therewith,, with corresponding LED array driver IC chips being connected in series. With such arrangement, the first one of the pair of LED array driver IC chips functions to drive, for example, the odd LEDs of the associated LED array, and the second one of the pair of LED array driver IC chips function to drive, for example, the even LEDs of the associated LED array.

In a second embodiment of the LED device in accordance with the present invention, the LED device comprises one series of a plurality of LED arrays and one series of a plurality of LED array driver IC chips. In a first aspect of the second embodiment, there are a same number of LED arrays and LED array driver IC chips with each LED array driver IC chip being used to drive a corresponding one of the LED arrays. In a second aspect of the second embodiment, each LED array driver IC chip has the capacity of driving more LEDs than found in each LED array. With such arrangement, there is a greater number of LED arrays than LED array driver IC chips.

An LED device constituted in accordance with the present invention has the LED array driver IC chips formed with input and output pads for the input and output, respectively, of a multiplicity of signals such as drive data signals to and from LED array driver circuits forming part of the LED array driver IC chips. Such LED array driver IC chip arrangement effects the communication of signals with adjacent LED array driver IC chips in a series, thereby incorporating the functions of the spreader board of the prior art LED device so that the present LED device can be made more compact.

The present invention and its various advantages will be better understood from the following more detailed description taken with the accompanying drawings and claims.

Brief Description of the Drawings

FIG. 1 shows a general structure of a conventional (prior art) LED device;
FIG. 2 shows a wiring schematic for the prior art LED device of FIG. 1;
FIG. 3 shows a plan view of a general structure of a light-emitting diode (LED) device in accordance with the present invention;
FIG. 4 shows a wiring schematic for the LED device of FIG. 3;
FIG. 5 shows a plan view of an LED array driver integrated circuit (IC) used in the LED device of FIG. 3;
FIG. 6 shows a general structure of a second embodiment of the LED device in accordance with the present invention;
FIG. 7 shows a general structure of a third embodiment of the LED device in accordance with the present invention; and
FIG. 8 shows a general structure of a fourth embodiment of the LED device in accordance with the present invention.

Detailed Description

Referring now to FIGs. 3 and 4, FIG. 3 shows an arrangement of an LED device 20 in accordance with a first embodiment of the present invention, and FIG. 4 is a wiring schematic showing the connections among the components of the LED device 20 of FIG. 3. The LED device 20 comprises LED arrays 22 (shown within a dashed line rectangle) and associated LED array driver integrated circuits (ICs) 21, an input board 23, a motherboard 24, an input connector 25, and wire bondings 26. Each LED array 22 comprises a number of LEDs 28 (shown in FIG. 4 only), and the number of aligned LED arrays 22 used in the LED device 20 have a length corresponding to the width of a paper used in an optical printer incorporating the LED device 20. In this first embodiment, each LED array 22 is connected to two LED array driver ICs 21, a first driver IC 21 disposed on one side of the LED array 22 for driving the even-numbered array LEDs and a second driver IC 21 disposed on a second opposing side of the LED array 22 for driving the odd-numbered LEDs 28. Wire bondings 26 are used to connect the LED array driver ICs 21 to the LEDs 28 of each associated LED array 22. Externally-supplied power and emission data signals for the LED device 20 are received by an input board 23 via an input connector 25. The power and emission data signals are transmitted from the input board 23 to the LED array driver ICs 21 by wire bondings 26 which also transmits signals between LED array driver ICs 21. The LED array driver ICs 21 and LED array 22 are assembled on a motherboard 24. Taking the input board 23 as being upstream, LED array driver ICs 21 are arranged in a downstream-oriented continuous chain of electrical connectivity.

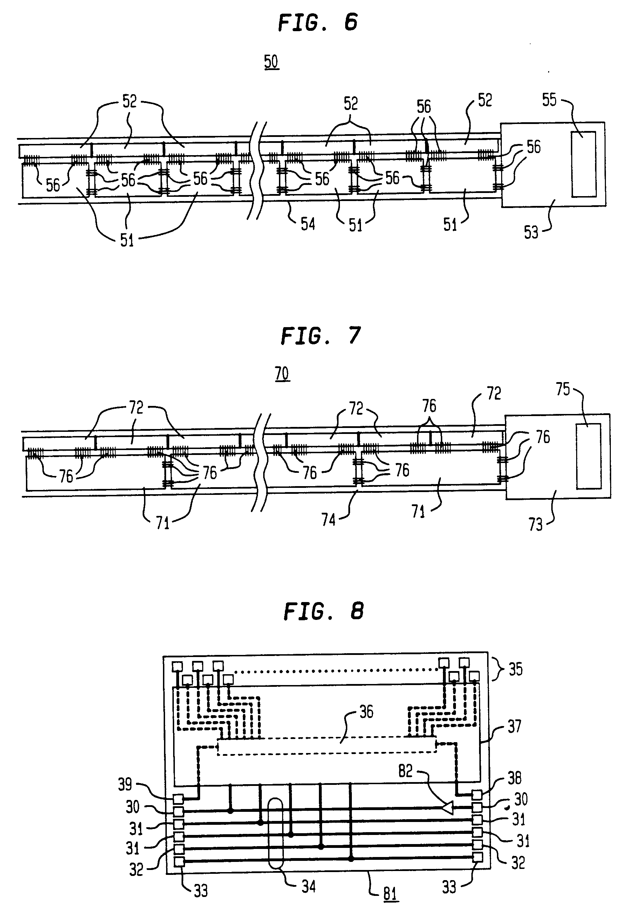

Referring now to FIG. 5, there is shown a plan view of details of an LED array driver IC 21. The LED array driver 21 comprises clock signal pads 30, control signal pads 31, drive current adjustment pads 32, power supply pads 33, internal wiring 34, output pads 35, an LED array driver circuit 37, a serial drive data input pad 38, and a serial drive data output pad 39. The LED array driver circuit 37 comprises a serial-to-parallel conversion shift register 36 (shown within a dashed line rectangle). The clock signal pads 30, control signal pads 31, drive current adjustment pads 32, and power supply pads 33 are connected to the LED array driver circuit 37 by separate leads of the internal wiring 34. Each of the output pads 35 are also connected to the LED array driver circuit 37

More particularly, the LED array driver circuit 37 is used for driving the associated LED array 22 (shown only in FIGs. 3 and 4). The serial drive data input pad 38 is used for providing serial data inputs to the LED array driver circuit 37 for driving the LEDs of the associated LED array 22 via the output pads 35. The serial drive data output pad 39 is used for outputting serial drive data from the LED array driver 37 to the next-stage LED array driver IC 21 in the series of LED array drivers 21 on one side of the LED arrays 22. The clock signal pad 30 is used for providing clock signals to all of the LED array driver ICs 21. The control signal pad 31 is used for providing control signals to all of the LED array driver ICs 21. The drive current adjustment pad 32 is used for adjusting the drive current of all LED array driver ICs 21. The power supply pad 33 is used for supplying power to all LED array driver ICs 21. In this manner, the serial drive data input pad 38, the clock signal pad 30, the control signal pad 31, the drive current adjustment pad 32 and the power supply pad 33 are connected to the preceding LED array driver ICs 21 in the series and is connected via the internal wiring 34 to the LED array driver 37 of the current LED array driver ICs 21. Additionally, the serial drive data output pad 39 that outputs signals from the LED array driver circuit 37 as well as the clock signal pad 30, control signal pad 31, drive current adjustment pad 32 and power supply pad 33 are connected to the next LED array driver ICs 21 in the series. The LED array driver circuit 37 processes signals inputted from the serial drive data input pad 38, clock signal pad 30, control signal pad 31 and drive current adjustment pad 32 so that these signals are outputted to each of the LED array drive input pads (not shown) of the LED array 22 in electrical current form.

In the operation of the LED device 20 shown in FIGs. 3, 4, and 5, power, drive data signals, clock signals, and control signals inputted via the input connector 25 pass via the input board 23 to the two opposing LED array driver IC 21 adjacent to the input board 23. The drive data signals inputted via the serial drive data input pad 38 and converted to parallel data by the serial-to-parallel conversion shift register 36 in the LED array driver 37 are inputted to the LED array 22 via output pads 35. Additionally, serial drive data that has passed through the shift register 36 is outputted without modification to the serial drive data output pad 39 using clock signal. Signals from the serial drive data output pad 39 of an adjacent LED array driver IC 21 on the upstream side are applied to the serial drive data input pad 38 of the next downstream LED array driver IC 21. In other words, the signals from the serial drive data output pad 39 of a LED array driver IC 21 are sent to the serial drive data input pad 38 of the adjacent LED array driver IC 21 on the downstream side.

The clock signal pads 30, control signal pads 31, drive current adjustment pads 32 and power supply pads 33 are arranged on the sides of each LED array driver IC 21 that face the adjacent LED array driver ICs 21 on the upstream and downstream sides. The internal wiring 34 connects the pads 30, 31, 32, and 33 on the upstream side of each LED array driver IC 21 with the corresponding pads 30, 31, 32, and 33 on the downstream side. In this manner, the signals coming from upstream of each LED array driver IC 21 are conducted to the LED array driver circuit 37, and are also transferred downstream without modification. By thus incorporating the functions of components such as the spreader boards 16 of FIG. 1 that take up space and also have adverse electrical effects into the LED array driver ICs 21, use of the arrangement shown in FIGs. 3, 4, and 5 enables the LED device 20 to be made smaller and capable of higher speeds.

Referring now to FIG. 6, there is shown an LED device 50 in accordance with a second embodiment of the present invention. The LED device 50 comprises a plurality of LED array driver ICs 51, a plurality of LED arrays 52, an input board 53, a motherboard 54, an input connector 55, and wire bondings 56. In the first embodiment of the present invention shown in FIG. 3, 4, and 5, two LED array driver ICs 21 are provided for each LED array 22. However, in the LED device 50 of FIG. 6, only one LED array driver IC 21 is provided for each LED array 52. This makes it possible to further reduce the size of an LED device. It is to be understood that the input connector 55, input board 53, the plurality of LED array driver ICs 51, and the plurality of LED arrays 52 are interconnected and function in a manner similar to that described hereinbefore for the LED device 20.

Referring now to FIG. 7, there is shown an LED device 70 in accordance with a third embodiment of the present invention. The LED device 70 comprises a plurality of LED array driver ICs 71, a plurality of LED arrays 72, an input board 73, a motherboard 74, an input connector 75, and wire bondings 76. In the LED device 70, the size of the LED array driver ICs. 71 are increased by increasing the number of array elements therein over that shown in the arrangement of the LED devices 20 and 50 of FIGs. 3 and 6, respectively. As in the LED device 50 of FIG. 6, each LED array 72 in the LED device 70 is driven by a single LED array driver IC 71. With such arrangement, in addition to smaller size and higher speed, the LED device 70 has the advantage of a reduced number of wire bondings 76 and thereby improves the device reliability.

Referring now to FIG. 8, there is shown another arrangement of an LED array driver IC 81. The LED array driver IC 81 comprises clock signal pads 30, control signal pads 31, drive current adjustment pads 32, power supply pads 33, internal wiring 34, output pads 35, an LED array driver circuit 37 including a serial-to-parallel shift register 36 (shown within a dashed line rectangle), a serial drive data input pad 38, and a serial drive data output pad 39. These components have the same structure and function as the correspondingly numbered components of the LED array driver IC 21 shown in FIG. 5. Additionally, the LED array driver IC 81 further comprises a line amplifier 82 interposed between the clock signal pads 30 on the input and output sides. As the waveform can, therefore, be shaped while the clock signal is being transmitted from one LED array driver IC 81 to the next, a higher clock speed can be used, thereby improving the performance of the LED device.

It is appreciated and understood that the specific embodiments of the invention described hereinbefore are merely illustrative of the general principles of the invention. Various modifications may be made by those skilled in the art which are consistent with the principles set forth.

## Claims

1. A light-emitting diode (LED) device comprising:
    an input connector for receiving a multiplicity of electrical power and data signals from an external source;
    at least one LED array, each LED array comprising a plurality of LEDs;
    at least one LED array driver integrated circuit (IC) chip connected in series with other ones of the at least one LED array driver IC circuits and located in the vicinity of the at least one light-emitting diode array for driving the LEDs of the at least one LED array, each LED array driver IC chip comprising;
    input pads for receiving the multiplicity of electrical power and data signals directly from the input connector when an LED array driver IC chip is a first LED array driver IC chip in the series of LED array driver IC chips, and for receiving the multiplicity of electrical power and data signals from an adjacent LED array driver IC chip in the series of IC chips when the LED array driver IC chip is not a first one in the series of IC chips;
    means for driving the at least one LED array in accordance with the multiplicity of electrical power and data signals received at the input pads; and
    output pads for outputting the multiplicity of electrical power and data signals as received at the input pads to a next adjacent LED array driver IC chip in the series of IC chips.

2. The LED device of claim 1 wherein the multiplicity of electrical power and data signals comprises electrical power and drive data signals, clock signals, exposure data signals and control signals.

3. The LED device of claim 1 wherein:
    the at least one LED array comprises a plurality of LED arrays mounted in a line on a substrate; and
    the at least one LED array driver IC chip comprises a plurality of LED array driver IC chips formed in two groups of serially connected IC chips, each group of serially mounted IC chips being mounted in a line parallel to and on a separate opposite side of the line of LED arrays from the other group of IC chips and comprise a number of LED array driver IC chips corresponding to the number of LED arrays, each IC chip being connected to an associated LED array for driving a predetermined group of the plurality of LEDs of said LED array.

4. The LED device of claim 1 wherein:
    the at least one LED array comprises a plurality of LED arrays mounted in a line on a substrate; and
    the at least one LED array driver IC chip comprises a plurality of LED array driver IC chips mounted in a line parallel to and on one side of the line of LED arrays, where theplurality of LED array driver IC chips correspond in number to the plurality of LED arrays.

5. The LED device of claim 1 wherein:
    the at least one LED array comprises a plurality of LED arrays mounted in a line on a substrate; and

the at least one LED array driver IC chip comprises a plurality of serially-connected LED array driver IC chips mounted in a line parallel to and on one side of the line of LED arrays, where the number of LED arrays comprise a number which is greater than the number of LED array driver IC chips.

6. The LED device of claim 1 wherein:
   the multiplicity of electrical power and data signals comprises serial drive data signals; and
   each LED array driver IC chip comprises a serial-to parallel shift register for receiving the serial drive data signals and converting the serial drive data signals into parallel drive data signals for driving predetermined ones of the LEDs of the at least one LED array, and for delivering the serial drive data signals unchanged to a next LED array driver IC chip in the series of IC chips.

7. A light-emitting diode (LED) device comprising:
   an input connector for receiving a multiplicity of electrical power and data signals from an external source;
   an input board for receiving the multiplicity of electrical power and data signals from the input connector and distributing the received electrical power and data signals to separate output connecting pads;
   at least one LED array, each LED array comprising a plurality of LEDs; and
   at least one LED array driver integrated circuit (IC) chip connected in series with other ones of the at least one LED array driver IC circuits and located in the vicinity of the at least one light-emitting diode array for driving the LEDs of the at least one LED array, each LED array driver IC chip comprising;
   input pads for receiving the multiplicity of electrical power and data signals directly from the output pads of the input board when an LED array driver IC chip is a first LED array driver IC chip in the series of LED array driver IC chips, and for receiving the multiplicity of electrical power and data signals from a next prior LED array driver IC chip in the series of IC chips when the LED array driver IC chip is not a first one in the series of IC chips;
   means for driving the at least one LED array in accordance with the multiplicity of electrical power and data signals received at the input pads; and
   output pads for outputting the multiplicity of electrical power and data signals as received at the input pads to a next adjacent LED array driver IC chip in the series of IC chips.

8. The LED device of claim 7 wherein the multiplicity of electrical power and data signals comprises electrical power and drive data signals, clock signals, exposure data signals and control signals.

9. The LED device of claim 7 wherein:
   the at least one LED array comprises a plurality of LED arrays mounted in a line on a substrate; and
   the at least one LED array driver IC chip comprises a plurality of LED array driver IC chips formed in two groups of serially connected IC chips, each group of serially mounted IC chips being mounted in a line parallel to and on a separate opposite side of the line of LED arrays from the other group of IC chips and comprise a number of LED array driver IC chips corresponding to the number of LED arrays, each IC chip being connected to an associated LED array for driving a predetermined group of the plurality of LEDs of said LED array.

10. The LED device of claim 7 wherein:
    the at least one LED array comprises a plurality of LED arrays mounted in a line on a substrate; and
    the at least one LED array driver IC chip comprises a plurality of LED array driver IC chips mounted in a line parallel to and on one side of the line of LED arrays, where the-plurality of LED array driver IC chips correspond in number to the plurality of LED arrays.

11. The LED device of claim 7 wherein:
    the at least one LED array comprises a plurality of LED arrays mounted in a line on a substrate; and
    the at least one LED array driver IC chip comprises a plurality of serially-connected LED array driver IC chips mounted in a line parallel to and on one side of the line of LED arrays, where the number of LED arrays comprise a number which is greater than the number of LED array driver IC chips.

12. The LED device of claim 7 wherein:
    the multiplicity of electrical power and data signals comprises serial drive data signals; and
    each LED array driver IC chip comprises a serial-to parallel shift register for receiving the serial drive data signals and converting the serial drive data signals into parallel drive data signals for driving predetermined ones of the LEDs of the at least one LED array, and for delivering the serial drive data signals unchanged to a next LED array driver IC chip in the series of IC chips.

## FIG. 5

## FIG. 1
(PRIOR ART)

10

# FIG. 2
(PRIOR ART)

FIG. 3

FIG. 4

# FIG. 6

50

# FIG. 7

70

# FIG. 8